Europäisches Patentamt

European Patent Office

Office européen des brevets

(11) Publication number: **0 097 430**
**B1**

# EUROPEAN PATENT SPECIFICATION

(45) Date of publication of patent specification: **20.07.88**

(51) Int. Cl.⁴: **G 08 B 17/12, G 11 B 7/24**

(21) Application number: **83302973.9**

(22) Date of filing: **24.05.83**

(54) Method for detecting fire.

(30) Priority: **25.05.82 US 381695**

(43) Date of publication of application:
**04.01.84 Bulletin 84/01**

(45) Publication of the grant of the patent:
**20.07.88 Bulletin 88/29**

(84) Designated Contracting States:
**BE DE FR GB NL SE**

(56) References cited:
**EP-A-0 023 809**
**EP-A-0 079 231**
**EP-A-0 083 396**
**AT-B- 365 810**
**DE-A-2 941 016**
**DE-A-2 943 203**
**US-A-2 799 600**
**US-A-4 222 071**
**US-A-4 252 890**
**US-A-4 285 056**

**IEEE Journal of Quantum electronics, Vol. Q E 17, No. 1, Jan. 1981, pages 69-77**

(73) Proprietor: **UNISYS CORPORATION**
**Burroughs Place**
**Detroit Michigan 48232 (US)**

(72) Inventor: **Shevlin, Craig Martin**
**5200 Piedmont Drive**
**Santa Rosa, CA 95405 (US)**

(74) Representative: **Kirby, Harold Douglas Benson et al**
**G.F. Redfern & Company Marlborough Lodge 14 Farncombe Road**
**Worthing West Sussex BN11 2BT (GB)**

Courier Press, Leamington Spa, England.

# 0 097 430

## Description

The present invention relates to a method for detecting presence of fire or flames.

This application contains material common to European Patent Application EPA—96501 which claims a method of fire detection using island films rendered transparent by incidence of radiation from a fire on an absorber layer after light has commenced incidence; common to Euorpean Patent Application EPA—96504 which claims a tri-layer structure using an island film of gold, gold alloy or palladium on a tin flash; common to European Patent Application EPA—98046 which claims a tri-layer structure using an island film of noble metal with antimony; and common to European Patent Application EPA—98045 which claims a method of preparing and displaying a transmissive mask using island films of gold with tin.

Introduction, background

Optical storage of digital data is a relatively new technology concerned with the storage and retrieval of digital information utilizing optical techniques, using a special related (ODD, "optical digital data") medium, such as an ODD disk. By analogy such data is conventionally stored on magnetic media like tapes or disks commonly used with high speed digital computers today.

This disclosure relates to a method for detecting fire or flames using a focused beam of prescribed radiation energy, especially low power laser equipment, similr to techniques used in optical data discs (ODD) recordings. Workers in the art have, for some time now pulzzled over how to develop a satisfactory ODD disk medium, especially one adapted for low power lasers presently available and exhibiting extended operational life—on the order of 10+ years!

According to the present invention, there is provided a method for detecting fire, said method including; provision on a transparent substrate of an absorber layer initially opaque and operative to become transparent in consequence of incidence of energy thereon from a thermal source; direction of an incident light beam onto said absorber layer; and detection of passage of said incident light beam through said absorber layer and said transparent substrate indicatively of incidence having occurred of said energy on said absorber layer; said method being characterised by; said thermal source being fire or flames; by said absorber layer being a gold alloy layer in the form of a finely divided plurality of islands; by said incident light beam being periodically incident on said absorber layer to preheat said absorber layer to a level insufficient to render said absorber layer transparent in the absence of said energy; and by said absorber layer being rendered transparent by agglomeration of said islands into larger globules having a cross-sectional area less than that possessed, pre-agglomeration, by those islands which have agglomerated.

United Kingdom Application GB—2,052,731—A discloses a thermal detection method wherein thermal energy is allowed to fall on an absorber layer on a transparent substrate, the absorber layer becoming less dense (i.e. more transparent) as a result of incidence of the thermal energy to allow passage of a light beam through the substrate onto a detector. The present invention seeks to provide improvement thereover by periodically providing the light beam to heat the absorber layer after incidence thereeon of the thermal energy, by providing the absorber layer as a finely divided island layer of gold alloy, and by using fire or flames as the thermal source.

Recording media for radiation beams generally:

Requirements for such ODD media are stringent; e.g. involving high bit density and cost-effective information storage at satisfactory read/write rates; preferably using low-power lasers. (Workers recognise the simplicity, speed and power of such laser implementation, where one need only modulate and deflect a laser beam for read/write operations).

In related applications (e.g. video disk recording) workers have used lasers and, for certain aspects thereof, have suggested media using metal film as an "information layer"—this layer to be softened, melted or vaporized (e.g., thermally ablated) by a write-laser-beam so as to form a "void" (a pit, hole, bubble, etc., or other deformation) in the layer as the "bit". Such a film may be coated on the surface of a rotating disk.

Some workers have felt that such laser recording would be promising for computer records of various kinds; e.g., the mentioned ODD media. They have predicted that practical systems await archival media which is responsive to low-power laser writing and that this in turn depends on whether one can find such an information layer (material) able to be melted (or vaporized, etc.) at current practical low-power levels. This may also depend on the radiation efficiency of the associated system.

Thus, workers have for some time been looking for such laser recording materials which exhibit high "thermal efficiency" (a measure of how much of the heat generated at the recording site remains sufficient localized to allow "pit" formation). For this they have considered recording materials with a low melting point and low thermal diffusivity (tellurium, lead, bismuth and indium are examples). The low melting point presumably facilitates a write-pulse of minimum energy—thus minimizing system cost or increasing bandwidth.

And, since workers feel one must use a low-power laser for such recording (e.g., to enhance the operating life of a laser and minimize its cost and size), it has seemed even more desirable that the metal chosen for such an information (absorber) film have an "outstandingly-low" melting point ("adequately-high sensitivity") so that the desired "bit-void" may be formed with minimal laser power.

2

Te absorber films: Example of prior art absorber layer

Now, many workers have contemplated using tellurium (Te) absorber films for this, or related, laser-recording. There are several reasons. Tellurium has an attractively low (bulk-) melting point (about 450°C), conducts heat poorly and appears able to provide good sensitivity and S/N ratio; also, it is relatively convenient to deposit as a thin film. Bismuth is also commonly suggested for similar reasons. And related alloys (e.g., as Te-Ge, Te-As-Se and Bi-Se) have been suggested as of interest.

Tellurium has been thought to exhibit a low write-threshold (energy)—e.g., when compared with Aluminum—as well as having a relatively low thermal diffusivity—e.g., see U.S. 4,222,071 to *Bell*, et al; also see "Review of Optical Storage Media" by *Zech*, SPIE Vol. 177, Optical Information Storage, 1979, page 56 et sequ.; and also see "optical Recording Media Review" by *Bartolini*, page 2 et sequ. of 1977 SPIE Vol. 123, "Optical Storage Materials and Methods".

For instance, this Bartolini article discusses such absorber films ("Ablative Thin Films") along with ten other optical recording means—including "Photopolymers", that is organic compounds known to undergo photochemical changes which involve a shift in refractive index. The Zech article discusses absorber films arranged and used so that with laser-writing a "pit" is developed in the absorber layer, this information being detected according to differential reflectivity (similarly for Bell patent).

For such known "deformational recording", it appears that the thermal energy delivered by a high intensity radiation beam ("Write-Beam" of a Laser) is such that the "write-site" will soften, melt or ablate, in at least part of the beam cross-section. Many believe that surface tension then causes a "transverse cavitation" (see article by Zech cited above), leading in turn to the formation of a "pit" or hole, usually slightly elliptical. (see "Melting Holes in Metal Films for Real-Time, High Density Data Storage" by Cochran and Ferrier, SPIE Proceedings, August 1977, pages 17—31).

European Patent Application 0,023,809 discloses an optical data storage medium wherein a continuous film of tellurium is used as an absorber layer in a tri-layer optical data storage disk. The present invention seeks to provide improvement thereover by providing a gold alloy layer in finely divided insular form, the property of the layer being exploited in a method for detecting fire where an optical shutter is rendered transparent (i.e. non reflecting) upon application of heat or radiation from a fire or flames to transmit light from a laser light source through a transparent substrate to a light detector.

United States Patent 4,252,890 discloses a photo optic recording medium comprising a thin layer of selenium, selenium tellurium alloys, tellurium, arsenic, zinc, sulphur, gallium cobalt, silver, cadmium, or even thermoplastics and waxes and paraffins as an agglomerable photo sensitive layer which can be caused to alter its reflection in a bi-layer or tri-layer structure for recording photographic images when light above a predetermined intensity level is incident thereon. This Patent also refers to the possibility of increasing the sensitivity of the imaging system by pre-heating. The present invention seeks to provide improvement thereover by providing a method employing a reflective energy-sensitive optical shutter in the form of a gold alloy island film as a means for detecting fire or flames where the shutter is rendered transparent (i.e. non-reflective) by incidence of heat or thermal radiation below the melting temperature of the island absorber layer, to allow passage of the light from a source, through a transparent substrate, to an optical detector.

In an article by Bartolini, Bell & Spong in the I.E.E.E. Journal of Quantum Electronics, Volume QE-17, No. 1 in January 1981 on Pages 69 to 77 thereof entitled "Diode Laser Optical Recording Using Tri-Layer Structures" there is disclosed the use of a continuous tellurium absorber layer over an optically transparent dielectric spacer layer and aluminium reflector layer in a tri-layer structure for use in recording digital data by disruption of the tellurium absorber layer using a modulated laser beam. The present invention seeks to provide improvement thereover by providing a method wherein the tellurium layer is replaced by a finely divided insular gold alloy layer requiring even less energy to cause agglomeration of the islands and wherein the layer is used on a transparent substrate in a fire or flame detector employing the layer and substrate as an optical shutter rendered transparent (i.e. non-reflective) by application of heat or radiant thermal energy from fire or flames operative to heat the layer to a temperature at least equal to a predetermined temperature below the bulk melting temperature of the absorber layer material to allow through passage of light from a source to an optical detector.

EP—A—0 083 396, not published at the priority date of the present Application discloses a gold-island absorber layer in an optical tri-layer for use as an optical data storage medium written by a low energy laser beam. The present invention seeks to provide novelty thereof by providing a method using a gold-alloy island absorber layer on a transparent substrate as a detector for fire or flames where the combination of the layer and the substrate form an energy sensitive optical shutter made transparent by application of heat from the fire or flames to allow through passage of light from a source to an optical detector.

EP—A—0 079 231, not published at the priority date of the present Application, discloses the use of thin gold absorber layers in optical trilayer structures for use in recording digital data using a low energy laser beam and further discloses the use as the absorber layer of a laminated layer of gold and tin wherein alternate layers of gold and tin are vapour deposited to form the absorber layer. The present application seeks to provide novelty thereover by providing a method employing the use of that and other types of gold alloy island deposited absorber layers in an energy sensitive optical shutter for detecting fire or flames rendered transparent (i.e. non-reflective) by application of radiant energy from the fire or flames.

The novel recording media and associated deposition techniques taught therein will be generally assumed as meeting the foregoing criteria; and, where possible, as also meeting one or more of the "target performance criteria" presented in Table I below. (See also "Optical Properties of Tellurium Films Used for Data Recording" by Ash and Allen, SPIE Proceedings, Vol. 222, 1980; "Design and Production of Tellurium Optical Data Disks" by Rancourt SPIE Proceedings, No. 299, 1981).

DE—A—2 943 203 describes a deformation process in connection with inter alia gold alloys and refers to antimony as a sensitivity material.

TABLE I
(Target criteria for media)

1. "High" sensitivity:
   allow recording by low-power laser means. "Sensitivity" will be understood as minimum laser power needed for bit formation (change in spot reflectivity, akin to that resulting from formation of a hole, or other void or like change in medium, giving adequate read-out at contemplated recording rate).
   With the invention, one may typically "write" with the order of 5—15 mW laser power for approximately 40—60 n.sec.; (pulse duration)—yet not degraded by read-out (i.e. on repeated playback).

1-A. High S/N: (adequate read-out)
   Signal to noise ratio (for adequate read-out) on the order of about 30—40 dB Min. peak signal to RMS noise.

2. "Archival Stability": (10+ years life):
   Able to be used or stored in "normal computer environment" without dropping below min. read-out for about 10—15 years (maintaining min. S/N).

3. "Computer records":
   Assume capability to operate with present day high speed digital computers—e.g., with at least the same capabilities as today's magnetic disk storage equipment (e.g., bit density of about $10^6$ bits/cm$^2$ or better)—Raw Bit-Error Rate" less than $10^{-6}$.

4. "Deposit-able"
   Suitable film(s) can be deposited on "commercial scale" and give repeatable, controlled characteristics.

5. Overcoat-ability
   absorber film can be super-coated (e.g. up to a few mils) to mechanically protect it and defocus "surface dirt" without sacrificing above features, e.g., still give adequate read-out (preferably overcoat can also impede heat and contaminant-gases, etc. from absorber film).

Thus it is an object hereof to provide the foregoing, and other related, features and advantages.

Brief description of the drawings

These and other features and advantages of the present invention will be appreciated by workers as they become better understood by reference to the following detailed description of the present preferred embodiments, these being considered in conjunction with the appended drawings, wherein like reference symbols denote like elements:

Figure 1 provides a cross-sectional view of an idealized portion of a prior art data recording medium employing a prior art absorber layer film;

Figure 2 provides a similar view of an optical data recording medium employing an absorber layer film such as can be used in the present invention;

Figure 3 shows a similar view of a disk record employing an absorber layer film suitable for use in the preferred embodiment;

Figure 4 is a plan idealized view of a certain recorded bit site;

Figure 5 is a sectional view of an exemplary structure employing an absorber layer useful in the preferred embodiment of the invention;

Figure 6 is a greatly enlarged plan schematic of a portion of the bit-site written upon according to the exemplary use of the absorber layer film;

Figure 7 is a plot of Reflectance vs wavelength for two different types of absorber layer film;

Figure 8 is a plan schematic view, greatly enlarged of a portion of one type of absorber layer film;

Figure 9 is a mechanical schematic of the preferred embodiment of the invention; and

Figures 10, 11, 12 and 13 are TE micrographs of various films suitable for use in the preferred embodiment.

Detailed description bf the invention

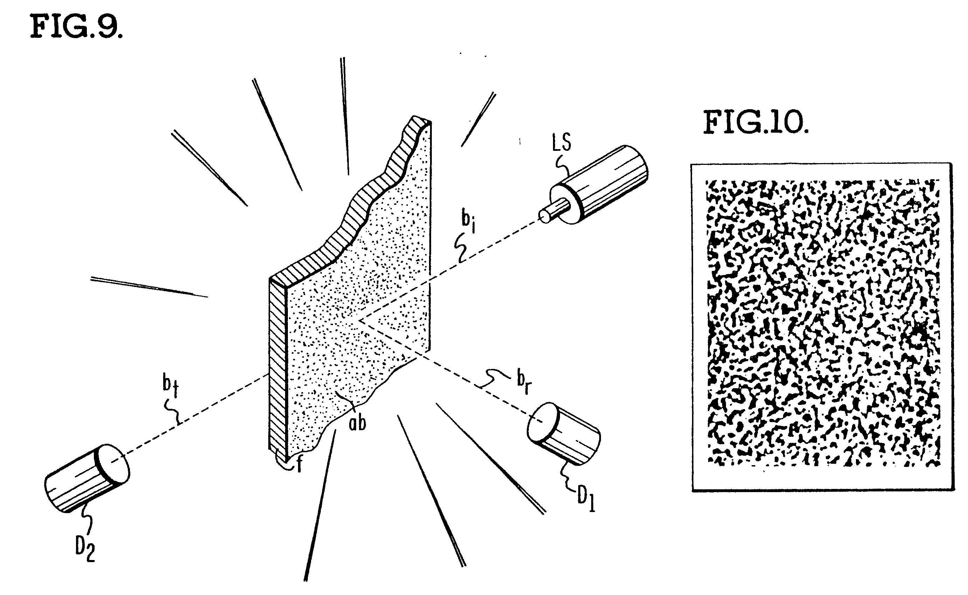

Heat-opened "Shutter film"; Figure 9

Figure 9 schematically illustrates the preferred embodiment of the invention utilizing "radiation agglomerated" island films. Here an island-film (ab.) is understood as deposited on a suitable substrate

4

(e.g., Au alloy on glass, with clear polymer overcoat, similar to following examples) within a frame member f. A radiant energy source LS (e.g., He-Ne laser at 633.8 nm suitable mw) is understood as constantly (or periodically) directing an incident light beam $b_i$ onto film ab.

Initially, film ab is adapted to reflect most of beam $b_i$ (e.g., as reflected beam $b_r$, towards a first detect unit $D_1$). However, when film ab (beam-impacted portion thereof) is heated to pre-set level by LS (e.g. to agglomerate-temperature—such as by a fire, flames nearby, etc.) it will agglomerate and "clarify" (relative to of $b_i$—so film ab now looks relatively transparent to $\lambda_1$). Now ab will pass beam $b_i$, as transmitted beam $b_t$ apt for detection at an associated second detect unit $D_2$.

Alternatively, light source LS could normally be inactive, but upon first emitting energy, direct a portion (as beam $b_i$) to unit $D_2$ and thereby melt an aperture in film ab.

Again, alternatively, beam $b_i$ could be scanned once across film ab to "write" a pattern therein—whereupon, with $b_i$ inactivated, a source of "backlighting illumination" could be projected at the entire "mask" so-etched (e.g. to generate a display or an optical printing plate). Workers will contemplate other like applications.

There follow examples of absorber layer (ab) films suitable for use in the invention, together with comparative experimental results indicative of their properties and performances.

Te "Example"; Prior art tellurium absorber layer ("Control")

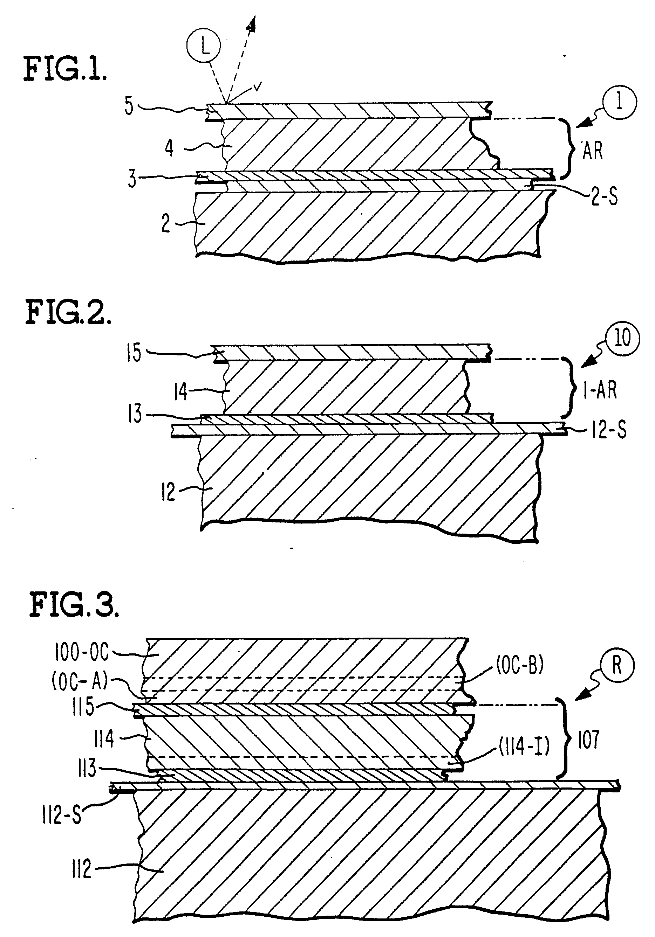

Figure 1 is a schematic illustration of an idealized cross-sectional view of an optical recording medium 1, understood as fabricated and operated generally along the lines of what is presently taught in the literature for tellurium (e.g., see Ash article). Medium 1 comprises a support 2 on which is provided an "anti-reflective" base AR and, on AR, an information layer ("absorber") 5.

Preferably base AR comprises a "reflector" layer 3, on which a transmissive "spacer" layer 4 is laid. Layers 3 and 4 may be characterized as, respectively, primarily reflective and primarily transmissive at the contemplated read/write wavelengths. Layers 3, 4, 5 will be understood as providing a multi-layer, low-reflecting (anti-reflection) design over most of the visible spectrum as known in the art (see Ash article).

Preferably, reflector 3 is an opaque laye (e.g. approx 60 nm found satisfactory) of aluminium or the like, while spacer 4 is transparent fused silica, or a like transparent dielectric, approximately one-quarter wavelength thick [i.e., $N \times \lambda/4$ where $N=1, 3, 5$ etc.].

Support 2 preferably comprises a polished aluminum disk of the type presently used in digital magnetic recording for computer disk drives, coated with an organic smoothing (subbing) layer 2-S adapted to render a satisfactorily-smooth, flat surface for deposition of reflector layer 3.

This will be understood as preferably comprising a 14" disk to be operated at about 1800 (to several thousand) rpm with good surface smoothness (e.g., order of less than 0.1 micro-metre peak-to-peak).

A radiation (laser) beam of prescribed energy and wavelength may be understood as applied to medium 1 from a laser source L, so as to establish a "pit" or like "deformation" on layer 5 as "writing" takes place (e.g. at site "v" shown in phantom). More particularly, it will be desired to use a 10 mW gaussian beam with diameter of 0.8 μm (i.e., 800 nm or 1/Σ) and scanning at 45 m/sec., to form a "pit" with a certain minimum length and width of 0.8 μm (though not necessarily circular or other prescribed shape,—this requirement is too stringent for conventional means however).

Prior art record 1 in Figure 1 will be understood as undertaken and described principally to provide a means of comparison and distinction for the invention embodiments in the following examples. And, except as otherwise specified, all materials, methods and devices and apparatus herein will be understood as implemented by known expedients according to present good practice.

Here, the metallic recording film 5 will be understood as deposited on the "transparent" dielectric spacer 4, with both thicknesses selected to yield a known low-reflectivity structure (e.g., in Bartolini article, less than 3% reflectivity obtained with 5 nm Ti on 80 nm $SiO_2$ spacer recording at $\lambda=488$ nm). Then, where each "pit" (bit) is recorded, this "anti-reflective" background will be disrupted such as to yield "bits" adapted for high-contrast read-back. And, where the recording wavelength is shifted, the spacer thickness is readily altered to give like results. In this "tri-layer" or "Dark Mirror" configuration surface reflectance (on absorber 5) can be made "zero" or a selected value by adjusting absorber thickness and spacer thickness. (A "tri-layer" being here understood as comprising a transparent spacer with absorber on one face and reflector on the other).

Workers will recognize that in certain cases the reflector film may be eliminated (e.g., in favor of a "dielectric mirror") and that spacer 4 may comprise other materials/structures (e.g. several layers of like material that is also more insulative thermally).

Thus, the coating parameters here will be understood as selected to preferably provide an "anti-reflective" condition for the so-coated disk at the contemplated recording frequency when the write beam is focussed on this absorber layer. [Regarding such see: *"Anti-reflection structures for optical recording"* by Bell and Spong, Journal of Quantum Electronics, Vol. QE 14, No. 7 July, 1978; and for general prior art, see exemplary articles: "Optical Disk Systems Emerge", IEEE Spectrum by Bartolini, et al, August 1978, page 20; and "Optical Recording Media Review" by Bartolini, SPIE Proceedings, Vol. 123, 1977, page 2; "Optical Storage Materials and Methods", SPIE Proceedings, Vol. 177, Optical Information Storage, 1979, page 56].

Preferably, deposition proceeds by thermal evaporation until the reflectance of layer 5 reaches a predetermined reflectance level.

As workers know, this may be done empirically, or by continually monitoring the reflectance of the absorber film (e.g., on a witness-chip) as layer 5 is deposited (see deposition techniques described by Zech in his cited article) or by like suitable optical techniques for deposition-monitoring; or by other known methods, such as monitoring deposited mass or by electrical properties.

Thus, one may vapor deposit an opaque layer 3 of aluminum onto coated disk 2 (all optical characteristics taken relative to contemplated R/W laser spectrum of 400—900 nm). Then, a layer 4 of $SiO_2$ (fused silica or like "transparent" dielectric) is vapor-deposited on layer 5 to a prescribed thickness, this thickness related to $\lambda_o$, the operating wavelength (—here, may be slightly less than either 1/4 $\lambda_o$ or 3/4 $\lambda_o$). Atop layer 4 is vapor-deposited the absorber 5 to a thickness which produces the prescribed reflectance (see below).

The reflectivity of the record medium 1 will be understood as modified at each bit-site "v" by the radiation beam from write-laser I, so that, upon detection with a suitable means, the "void areas" v (i.e., "pits") may be distinguished as relatively "high reflectance spots" from the low reflectance "non-void" background surrounding them, as known in the art.

For instance, U.S. 4,285,056 to Bell describes a like medium where information is recorded as "openings" in both the absorber and transmissive spacer layers, with the lengths of the openings and of the unexposed intervening areas being varied along a specific information track to convey frequency information. This patent also calls-out various materials (e.g., among them titanium, rhodium, platinum, gold, nickel, chromium, manganese and vanadium) to be deposited using standard evaporation or electron beam evaporation techniques. By comparison, U.S. 4,183,094 to Keezer et al, calls for laser recording on Te-Ge-Se-S materials to yield "interference changes" without creating such pits.

However, Bell diverges from what is contemplated here in requiring that his spacer layer be heated by the write beam—heated sufficient to either be itself ablated-away (i.e., to otherwise develop a void within itself) or else to be decomposed or sublimed and then out-gas sufficient to cause a "bubble" lifting the super layer (e.g., of gold)—in the present case, essentially no beam energy is to be absorbed by the analogous spacer layer.

Tellurium is a "low melting point/poor conductivity" metal commonly preferred by workers because it is felt to exhibit superior sensitivity, thus minimizing required (threshold) laser write-power.

For instance, this feeling is expressed in U.S. 4,222,071 to Bell and Bartolini, where similar tellurium films were characterized as requiring laser-power on the order of 15+ mW for writing thereon (to achieve adequate read-out, about 20% optical efficiency being assumed—the goal being to permit recovery of recorded video signals with about 40—50 dB S/N or "broadcast quality" read-back).

[They also specified a solid state Ga-AL-As injection laser, apparently applying a continuous beam about one (1) micron in diameter at the record surface, which is the while kept moving past this beam].

U.S. 4,222,071 stresses that the absorber must be a "low melting point metal" like Te (as well as being deposited in a "continuous film", and not as "microscopic agglomerates"; i.e., evidently not as "islands" or in "insular" form as below).

Preparation of absorber layer 5; (Figure 1):

Absorber layer 5 preferably comprises a relatively thin layer of tellurium which is vapor deposited (thermally evaporated) onto spacer layer 4 (on a relatively flat—~≤1/20λ—record surface thereof. The Te is so evaporated in a high vacuum preferably using a large batch coating chamber with corresponding large coating distances and "double-rotation" of substrate, etc. to better ensure uniformity—e.g., using a refractory metal boat for a source [1.2 m box type coating chamber used in Ash article]. All dust and stains on parts should be reduced to a strict minimum, using the most rigorous "Clean Room" techniques.

Substrate 2 comprises a flat, aluminum plate polished to desirable flatness and coated with "subbing" 2-S to appropriate flatness to accommodate deposition of thin reflector layer 3 (high reflectivity over at least the "working portion" of the contemplated radiation spectrum). About 60—90 nm of aluminum (prefer about 60 nm, vapor-deposited) has been found satisfactory. Since aluminum is not a perfect reflector, workers will recognize that in some cases one will substitute a "multi-layer dielectric stack" or the like.

The spacer 4 is likewise deposited atop reflector 3. Spacer 4 is a dielectric material which is relatively transparent to the "working portion" of the laser spectrum. About 158.3 nm of vapor-deposited $SiO_2$ (silicon dioxide) has been found satisfactory for the subject purposes (e.g., for write/read at λ=632.8 nm).

The tellurium absorber layer 5 will be understood as highly absorptive of the contemplated recording laser spectrum (e.g., typically 25% absorptive; 30% reflective; with about 45% of the beam energy transmitted (for trilayer cancellation, must transmit more than reflect). The thickness of absorptive layer 5 depends on that of spacer 4. Where transmitted light should be reduced, one may wish to increase spacer thickness (in N×λ/4 periods—also reducing heat-loss possibly).

Workers would view the Te absorber 5, with its low melting point and a relatively short thermal diffusion length (poor conductivity) as a good, "high sensitivity" material which helps conserve incident laser energy. When a write beam from laser source L falls upon site "v" of layer 5, a small portion of its energy will be reflected, a small portion absorbed and a large portion transmitted—the transmitted portion being reflected back by layer 3 to be (principally) absorbed in layer 5. Hence both incident and reflected energy will heat film 5, minimizing transmission losses (note: deposition of 5 yielded a "tri-layer"). Variations in absorber thickness or uniformity should be scrupulously avoided since this can reduce the write-energy coupled into the absorbing film and degrade sensitivity.

Results: prior art tellurium absorber layer

For present purposes, "Sensitivity" will be understood as characterizing the write-energy $E_w$ necessary to change reflectivity (or a like read-out characteristic) sufficient to give the specified minimum read-out.

The intensity and time exposure of the focused Write-Beam will be understood as sufficient to so elevate the temperature of absorber layer 5 as to cause the indicated change in reflectivity (at v sites) giving the desired read-out quality, etc. (e.g., so that adequate contrast, S/N ratio) may be realized, as understood by workers in the art,—cf. an exemplary S/N ratio of 40—50 dB (peak-to-peak signal vs. RMS noise) for a bandwidth of about 15 MHz.

Here, test recording is to be performed with a gas (He-Ne) laser beam operating at 632 nm, with recording exposure from 30—470 n.sec. (usually 10 mW, 40 n.sec. or about 400 p.J.—this intended to yield minimum adequate read-out, or about 40+dB S/N, when read at lower power; e.g., viz: 150—500 pJ/cm² ($pJ=10^{-12}$ watt-sec. or Joules), with the same or similar laser equipment. Note: for this contemplated setup, assume laser focused on bit site of $\sim\frac{1}{2}$—1 micron diameter, (i.e., 500—1000 nm) and thus a write-pulse about 40 n.sec., long [60 n.sec. from rise to fall—this also accommodating disk rpm of 1800 and associated galvo-mirror focus characteristics].

The subject record 1 is so-recorded upon. It is found (relating to comparable situations in the literature, etc.) that relatively low-power laser pulses can melt the Te film sufficient to yield the well-known "pits" or "craters" and give good read-out (e.g., bit reflectance of ~50% vs. background of 1—3% at $\lambda$=632.8 nm)—however with quite a bit of "noise" too.

Such "bit-bits" will be seen to constitute actual voids (e.g., see photos in Ash article where 2—10 mW, 100 n.sec. laser pulse recorded such "craters" in like Te films—there, it was assumed that a 25 nm film of Te used in the reflective mode produced 57% reflectance, 6% transmittance, 37% absorptance at 450 nm).

However, despite the fact that such Te films are deposited as a continuous layer, the formation of the "bit-pits" (v) is described in the literature as accompanied by a surrounding rim—and it is thought that this rim is responsible for (much of the mentioned "noise").

Evidently one needs a certain MIN. Write-Energy $E_w$ within a certain minimum rise-time (e.g., with *this* laser etc. about 10 mW within 40 n.sec.) to render adequate "holes" (e.g., higher power delivered too slowly can allow heat-at absorber to leak away; thus no "bit" is written).

Such "holes" or "pits" are suggested by the hole-site at "v" in Figure 1. At least some of the absorber material 5 is then evidently softened and displaced at that bit-site, sufficient to reduce its thickness there and so give increased reflectivity (at least that is what the art conventionally teaches, e.g., see Ash article and cited U.S. 4,222,071).

Such a spot may be read-out with means known in the art; e.g., with a similar laser at low power (e.g., above described laser at 3 mW), the increase in reflected energy received) at a suitable photo-detector) is obtained to yield an output signal representing the recorded bits, these being readily distinguishable from background—this read-energy being insufficient to "erase" or disturb the so-recorded bits, of course. [Note: read-out at a frequency $f_R$, where "pit-depth" introduces a phase change vs. light reflected at surface of Te such as to maximize contrast therewith].

Archival stability: prior art tellurium absorber layer

I found that the archival stability of this "Te record" was extremely poor, as the literature has noted (e.g., see Ash article re oxidation, etc.). For instance, under known temperature-humidity cycling, record 1 will be found (using no overcoat on layer 5) to gain 50% of its reflectivity in about 2—3 weeks, evidently mostly via oxidation, etc. (cf. a "hole" should have "high" relative reflectance—oxide increases "background reflectance" between holes—washing-out necessary S/N). The Te film of Example I will be found characterized by a rapid increase in overall optical transmission after such "aging". This is presumably caused by a general oxidation of the metal as well as severe selected site-attack beginning at "defect sites" in the metal film, (cf. analogous test per MIL SPEC #810-B).

This is grossly inadequate for the mentioned "archival memory" requirements (about 10 years exposure to normal computer operating/storage conditions; see Table I).

Low temperature absorber layers

The following Examples are given by way of teaching some exemplary uses and advantages of "low temperature" absorbers in island-film form.

Advantages and features thereof will be better appreciated by comparing them with the "Te Example" described above.

Example I: Gold material absorber; not comprised within the invention

The operations, materials, methods and structure of the "Te Example" (Figure 1) described above are repeated here, except as otherwise specified, in a novel record 10 (Figure 2) having a "gold-absorber" film 15 replacing the tellurium film 5.

Record 10 will be understood as comprising a support 12 on which an "anti-reflective" base 1-AR is laid (like AR in Figure 1, preferably comprising a reflective layer 13, with a transmissive spacer layer 14 laid upon 13), with absorber film 15 placed atop substrate 1-AR (spacer 14 thereof).

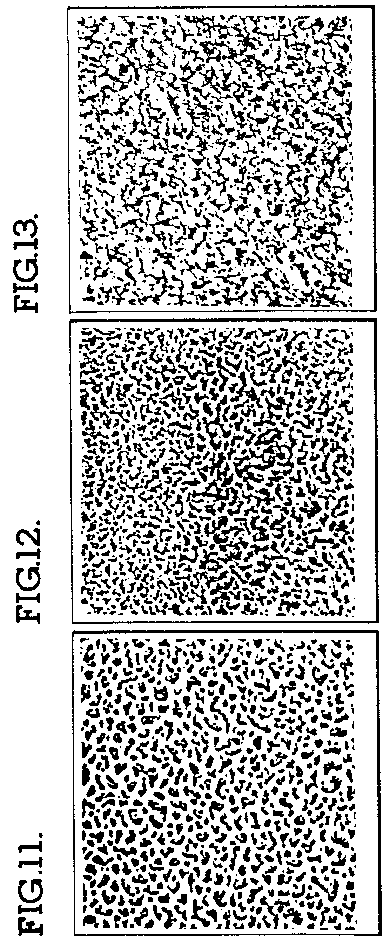

Here, and according to a feature hereof, absorber 15 comprises a film of "gold material" comprising an "island layer" deposited to function as an absorber film (somewhat like the Te film in the "Te Example", e.g., in a somewhat similar process and by similar means). Here, very close attention is paid, during deposition, to controlling absorber thickness so that it yields a prescribed minimal "Dark Mirror" reflectance $R_m$ (e.g., here 10% was chosen) as further described below. Importantly, film 15 is formed to be discontinuous, being formed in an island configuration for optimal results, as shown in Figure 11 (100,000×Te micrograph) and as described below.

The underlying spacer layer 14, reflector layer 13 and substrate 12 are (at least functionally) otherwise the same as in "Te Example", and thus will be understood as functioning as a "tri-layer", with absorber 15, as understood in the art (e.g., see cited references).

Thus, gold absorber film 15 is preferably formed by vapor depositing a gold material on the surface of $SiO_2$ spacer 4 until (monitoring the well known "tri-layer" effect) surface-reflectivity of 5 first drops to preselected value $R_m$ (10% reflectance here), taking care to render the "insular" configuration. Reflectance $R_m$ may, conveniently, be set at any desired value consistent with adequate "writing" and read-out. Here, about 10% was arbitrarily selected (minimum for proper focusing, etc of this laser) and "writing" with the mentioned laser beam (as in Te Ex.) shifted reflectance enough to give adequate read-out in the described manner (i.e. a "written spot may be seen to exhibit 25—55% reflectance, yielding the desired S/N in the 25—40 dB range—in some cases a 30—50% increase is satisfactory). Workers will appreciate how other "minimum reflectance" values may be chosen for the "virgin" absorber film.

Preparation of absorber layer 15; (Figure 2);

Absorber layer 15 thus comprises an extremely thin "island-deposit" of gold which is vapor-deposited (thermally evaporated) onto spacer layer 14 (i.e., on a relatively flat; e.g., 0.5 λ record-surface thereof). I found that if gold is so deposited on this "tri-layer coating" only until such a "minimum reflectance" $R_m$ as 10%, the "islands" are formed such that, when subjected to the described laser write-beam (633.8 nm, 10 mW for 40 n.sec. etc.), reflectance changes significantly; quite enough for adequate read-out (e.g., going from about 10% to about 25—55%—see below for detailed discussion of results).

The absorber film 15 is thus preferably vacuum deposited on spacer layer 14 using present preferred techniques (e.g., "pure" gold has been so deposited in large vacuum chamber at $\sim 10^{-6}$—$10^{-7}$ Torr., from a molybdenum boat which was resistance-heated—deposition rate was about .5—.1 nm/sec.).

Preferably, the silica layer 14 was, itself, likewise vapor-deposited before receiving the gold film 15. All substrates were cleaned according to present good practice for optical thin films.

It is important that this deposition (by thermal evaporation) proceeds only until the reflectance of film 15 first attains the predetermined "minimum-reflectance level" ($R_m$) yielding the desired "islands"— otherwise the subject results may not occur.

As workers know, this may be done empirically, or by continually monitoring the surface-reflectance of a witness-chip while absorber film 15 is deposited until satisfactory "islands" appear (and see deposition techniques described by Zech in his cited article, or by other known methods, such as monitoring deposited mass or electrical properties during deposition).

Results: Exemplary gold island absorber layer

Record 10 was recorded-upon, read-out and evaluated with its sensitivity, etc., measured, as in the "Te Example" (e.g., using an He-Ne laser system of the type mentioned). The so-written bit sites appear to be "agglomerate-holes" (where absorber has been made to "agglomerate" and where absorber material may also be caused to migrate toward the hole-periphery, or beyond)—this across a hole-diameter comparable to that of the read-beam (e.g., $\frac{1}{4}$—$\frac{3}{4}$ thereof); to exhibit a like increase in reflectance and higher output signal.

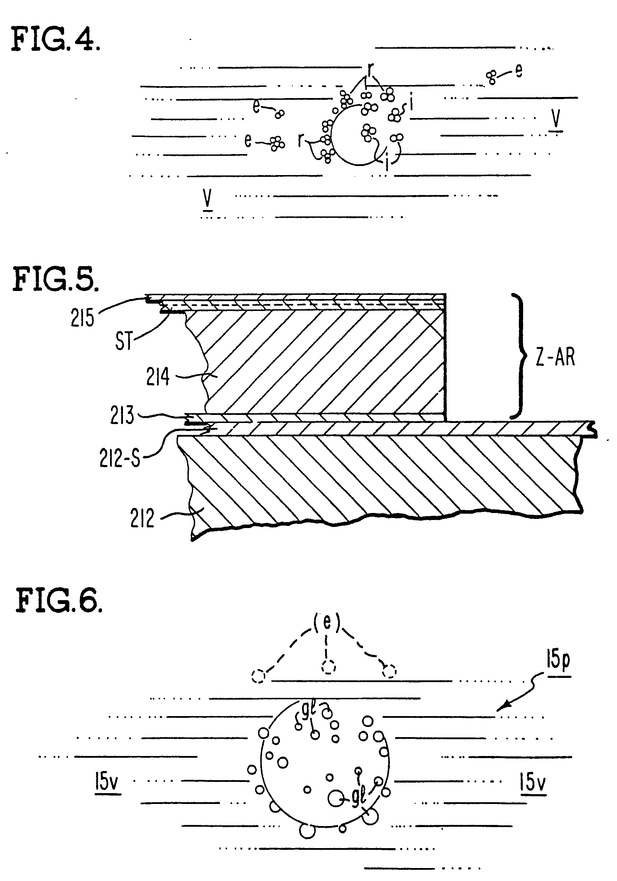

Figure 6 is an artistic rendering showing such an "agglomerate-hole" (or "quasi-pit") as seen in photo-micrographs of such records. Here an "agglomerate-hole" $15_p$ will be understood as a somewhat-circular written-spot, or physical-optical discontinuity in the virgin unwritten absorber film $15_v$. Spot $15_p$ will be on the order of laser beam-diameter (e.g., 40—120% thereof) and may include a "rim" or partial-rim about its periphery. Within the rim, relatively less absorber material is usually present; what there is will be seen as consolidated into absorber-globs gL, most of which are relatively large (e.g., usually fewer, many being larger than the tiny "islands" of virgin film $15_v$ and Figure 11, (and lie relatively farther apart). In effect, spots $15_p$ will be understood as constituting an "optical void" or discontinuity at the selected read-wavelength ($\lambda_w$); whereas the virgin island film $15_v$ appears as a relatively continuous (partial) reflector.

Thus, workers will appreciate how such "agglomerate-holes" $15_p$ can be the functional equivalent of conventional pits like those known with tellurium (see Te Ex. and references cited).

As detailed below, one finds that such an "insular" absorber film can yield a superior record; one giving considerable archival stability, unexpectedly-high sensitivity and high S/N while requiring surprisingly low write-energy and low write-temperature evidently—and also apparently having good tolerance to an overcoat. [E.g., where a useful overcoat doesn't degrade operational performance beyond practical usefulness—as it presently does with Te absorbers, perhaps because these evidently require a relatively massive translation of absorber material—in contrasdistinction, workers will be pleasantly surprised to note that the invention can "record", i.e., "open" a hit-hole to pass the Read beam, without necessary so-translating most or all of the absorber out of the bit-site—instead the invention can operate by merely "agglomerating", and thus redistributing absorber within the bit-site, with little or no material necessary moved outside the site, or ablation-ejected therebeyond, etc.]. Details are given below.

Island form of absorber film:

Figure 11 is a microscopic plan view (100,000×TE micrograph) of the original, virgin (i.e., unrecorded-upon) reflecting surface of an Au absorber film like that above-described. It will be evident that this surface appears as a physically discontinuous, or partly discontinuous, "insular" configuration exhibiting a fairly regular pattern (semi-islands on the $SiO_2$ spacer). For this Ex. I, the islands will be understood as having diameters on the order of a few tens nm (e.g., 10—30 nm typical), separated by intervals of comparable dimension (e.g., 5—20 nm apart—vs. laser beam 500—10,00 nm wide; cf 632 nm wavelength). The virgin film 15 will thus exhibit a certain "% void" range (e.g., a few % to 10% voids).

Now, subjecting a portion of this virgin film to a laser recording beam as described acts to "agglomerate" these "islands", increasing the "percent void" in the site (larger island-spacing) and ejecting some island mass out to the site periphery and beyond, (see ejecta e) forming a (small, not necessarily continuous) "rim" there in some cases—thus forming an "agglomerate-hole" as in Figure 6, this process is, here, loosely characterized as "agglomeration".

At least some of the first-order factors controlling such island formation are: absorber material, deposition-rate, adhesion; substrate material and condition (e.g., cleaning, roughness, etc.) and temperature; presence of "nucleation layer", presence of vapor-contaminants (vacuum pressure) and like factors as will be appreciated by workers. For example, too-cool a substrate will render a continuous film, but too-hot will leave no film at all. In this regard workers may compare Figures 12 and 13 with referenced Figure 11. In Figure 12, a similar film was prepared (like Ex. I) except that the silica substrate was coated with a bismuth oxide layer for nucleation as known in the art. Figure 13 was similar, with a chromium nucleation layer instead. Compared with Figure 11, Figure 12 seemed to exhibit thinner islands farther apart, while Figure 13 is a continuous gold film (no islands).

The cited laser apparatus could not "write" at all on the film of Figure 13 (at cited power level); while the film of Figure 12 wrote like that of Figure 11 (Ex. I) except for a bit lower sensitivity.

Workers will appreciate that such "island" pattern can render certain desired results—taking into account such factors as read/write conditions (e.g., write-energy, beam-width, $\lambda$, etc.). Thus, in Ex. I satisfactory "bit holes" about 400 to 1,000 nm diameter were formed with the specified write-beam, etc. (gave satisfactory S/N, etc.).

One infers that island-diameters which are either too large or too small will not be satisfactory. More particularly, it seems that the virgin size and spacing of the islands should be such as to accommodate the described agglomeration, upon recording, with average island diameter well below anything approaching a continuous film (i.e., sufficient spacing—percent void to thermally isolate individual islands); yet large enough (% void low enough) so that absorber film 15 "appears" like a (relatively continuous) "optical reflector" at selected $\lambda$ (R/W lasers). And spacing is presumably large enough so that when a spot is laser-heated (written-upon) it will so "agglomerate" as to form the indicated "agglomerate-hole" causing the film 15 to "optically switch" and exhibit a significant shift in detected reflectance (consistent with required S/N, etc.—i.e. so the "spot" becomes "relatively transparent" now and appears relatively "open" (transparent) to the optical system concerned, as with a conventional "pit").

Stated otherwise, the write-beam is assumed, here, so as to affect the islands in a bit-site as to cause "agglomeration" and the (usually) attendant increase in average island size and spacing (increased % void area). One infers that the initial (virgin)% void will be sufficient to accommodate a prescribed minimal heat loss, radially, yet not so large that initial reflectance ($R_o$) exceeds the desired "near zero" value (required for a "Dark Mirror").

Of course, where a tri-layer is formed with its optical substrate, this will make the absorber-spacer-reflector effectively increased in reflectivity (e.g., as here, from about 10% to about 30%).

In general, one may describe this writing operation as so energizing the absorber film as to, in effect, significantly separate absorber mass at the bit site. Thus where an unwritten spot may exhibit 25% absorption— 45% transmission— 30% reflection, a "so-written" spot may shift these values to about 30%—10%—60%, respectively, for the subject write wavelength (tri-layer).

As this "writing" so increases the percent void (area), one infers that the write beam evidently so energizes the islands at the write-spot that their average size increases and their average spacing increases (i.e., they "agglomerate" fewer islands).

"Island-films" as such:

Now, "thin metallic films in island form" have received some attention in the literature as a general proposition (e.g., see article with this little by Doremus in J. App. Physics: June '66, Vol. 37, #7, pp 2775 et sequ. where gold films were described—also see "Optical Constants of Aggregated Gold Film" by Truong, et al. in Journal of Optical Society Am. Vol. 66, #2, February 1976, pp 124 et sequ. where such films were formed by evaporating onto hot glass substrates at 200°C, and wherein the authors opine "it is reasonable to assume that the particles themselves have the bulk optical constants"; also see "Structural and Electrical Properties of Discontinuous Gold Films on Glass" by Andersson and Norman in "Vacuum", Vol. 27, #4, 1977, Pergamon Press, Great Britain: studying electrical resistance of such films, indicating that this resistance exceeds that of the bulk gold).

Yet no worker appears to have discovered that there is any advantage to useing any such "island films" as an ODD laser recording medium, whether of gold or any other metal. Indded workers appear to have contemplated only "continuous" absorber films (e.g., see cited U.S. 4,222,071 specifying that the absorber should "*not* be agglomerated" but should be a "continuous film"; or see IBM-TDB of March '71, pp 3001 teaching a continuous "metal layer such as gold plus an amorphous sub-layer" like amorphous silicon- these layers to be heated to form "a mixture of gold, crystalline silicone and amorphous silicon", etc.).

Ex II: as I, use Au/Sn: preferred absorber layer

Ex. I is replicated except that instead of pure gold, the (evaporo-deposited) absorber constitutes gold plus a minor concentration of tin. This is laid-down as a laminate for convenience of deposition: first gold, then tin, then gold (alternatively, one can add other dual layers of tin and gold too). Upon heating, this "laminate" should inter-diffuse to form (mostly) a Au/Sn alloy (mostly gold, so "gold characteristics" should predominate).

This Au/Sn film is substituted as the island-film of Ex. I (for 15 in Figure 2) and is similarly written-upon. Effects: were qualitatively similar to Ex. I, while exhibiting greater superior archivability and somewhat inferior sensitivity.

Adhesion of Au: preferred absorber layer

It was also observed that the gold islands adhered quite poorly to the cited silica (e.g., easily wiped-off). And, when a clear polymer spacer was substituted (for better thermal isolation, etc.), the gold deposit would not really adhere at all (zero sticking coefficient).

Accordingly, a thin tin "strike" (predeposit in island form—see Ex. III) was conceived and applied as a "nucleation film", and this was rendered on the glass (followed by Au-island deposit). Later a polymer spacer was used. As Example III shows the results were highly promising especially with the polymer substrate—with the adhesion of gold vastly improved, but its island configuration not compromised apparently.

Ex. III—Au on Sn Flash/Polymer: Preferred absorber layer

Figure 5 depicts a replication of Ex. I, (Figure 2), except that a clear polymer is used as spacer (e.g. Teflon) and a tin-flash ("strike", as adhesion promoter etc.) is interposed under the pure-gold absorber. Thus, as before, we have a disk 212, a subbing layer 212-S on the disk, then a tri-layer 2-AR consisting of reflector 213, (clear Teflon or like polymer) spacer 214 and absorber 15 (pure Au, in island form, deposited however on Sn layer ST of islands). This was similarly written-upon.

Results

Like Ex. I but much improved gold adhesion, sensitivity, read-out and archivability. That is, the gold (islands) adhered tightly to the substrate (Sn islands on clear polymer spacer). Sensitivity and read-out were much improved accordingly it is believed that is Sn strike not only improves adhesion (to polymer) but also "coperates" to enhance the optical read-out—something very surprising.

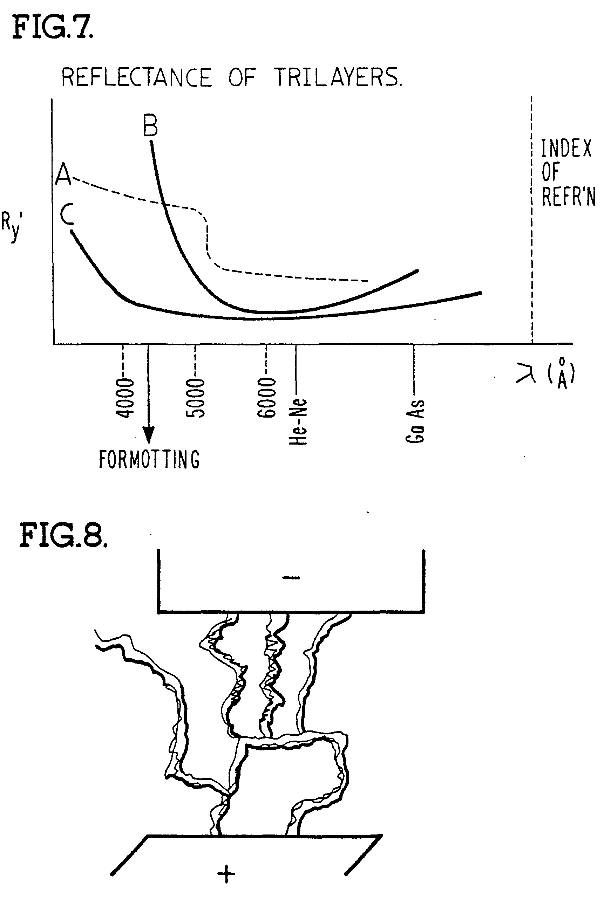

One such surprising optical effect is indicated in Figure 7, a plot of wavelength vs. reflectance (and index of refraction) of virginal island films. A pure gold island absorber like that of Ex. I might exhibit a shift in refractive index as portrayed by curve A and a reflectance/λ characteristic as in curve B. This obviously inhibits operating well above or below the He-Ne laser spectrum (633.8 nm—e.g., desired formatting of OD disks is not feasible at 440 nm, etc.; alternate use of Ga-As laser not feasible either). Quite surprisingly, adding the Sn (island-) strike served to "flatten" the absorber's reflectivity curve as indicated at curve C. Workers will appreciate how significant such an increased radiation bandwidth can be.

The archivability of Ex. I (pure Au on SiO$_2$) leaves something to be desired (e.g., in resisting intrusion of water vapor—perhaps because of its very poor adhesion); whereas this Au/Sn island array was much better.

Of course, the polymer is quite heat-degradable; accordingly the deposition steps (for Sn, then Au) will keep within its temperature limits (~100°C). Such gold films should be equal to the "archival" conditions specified here. It is projected that such "gold records" can maintain adequate read-out (30+ dB) for the order of ten (10) years under typical contemplated storage and use conditions.

Ex IV: as III with overcoat: preferred embodiment

Ex. III is replicated, however adding a clear polymer supercoat on the absorber layer 15 as a protective overcoat.

Results:
Similar to Ex. III except that sensitivity is degraded a little, though is still passable. Such tolerance to overcoating is a noteworthy property; much desired in the art.

Ex V: as III, alloy co-deposited: preferred embodiment
Ex. III is replicated except that the tin is co-deposited (in same minor %) with the gold (rather than as a preliminary "strike").

Results: quite similar to Ex. III.
Ex. VI: as III, $SiO_2$ on polymer: Preferred embodiment
Ex. III is replicated except that a thin layer of $SiO_2$ in superposed on the polymer spacer 214 (Figure 5), with the Sn strike deposited on the $SiO_2$ then the gold.

Results
Comparable to Ex. III, but sensitivity reduced considerably. It will come as a surprise to workers that such polymer spacers are feasible and that silica is disfavored (silica is widely reported as preferable).

Ex. VII: Au/Sb preferred embodiment
Ex. VI is replicated except that antimony replaces the tin (strike on $SiO_2$—on polymer).

Results
Superior sensitivity to foregoing examples yet with very inferior archivability and, surprisingly more apt to form intra-hole agglomerates and ring-agglomerates (see Figure 4, elements i, r respectively) than "ejected" globs (see e, Figure 4—relatively few ejecta e here; e.g., vs. prior Examples)—Figure 4 is an idealized showing of a typical "agglomerate-hole" written on such an Au/Sb absorber, the "virgin" island configuration v not shown here.
The latter property (tendency to favor ring and localized agglomerates rather than "ejecta") is striking—it suggests a susceptibility for controlling the extent of agglomerate migration, and also suggests a hole-forming mechanism likely to be minimally effected by overcoatings (which can be expected to block all "ejecta" e).
Co-depositing such an Au/Sb alloy (same conc.) will give comparable results.

Ex. VIII: Au/Sb/Sn preferred embodiment
Ex. III is replicated (Sn strike on polymer) except that an antimony "strike" follows the Sn strike, with gold deposited thereafter.

Results
Quite similar to Ex. VII, with sensitivity a bit worse, archivability a bit better and the same general tendency toward minimal "ejecta" (as in Figure 14, but a bit more than Ex. VII). Co-depositing the Au-Sn-Sb will yield the same kind of results.

Ex. IX: Au/Pb laminate preferred embodiment.
Ex. II is replicated, except that tin is replaced by lead so the absorber film 15 (Figure 2) comprises successive island-layers of: gold-lead-gold-lead-gold, each in proper island configuration. When heated, these island layers will readily inter-diffuse (distances so short) to form Au/Pb alloy-islands (Au major constituent, so ignore Pb properties as a first approximation, i.e. thus alloy will exhibit "gold characteristics" predominantly).
While film 15 is so deposited as a "laminate" for testing convenience, other methods will occur to workers.
[Note: this "laminar" form of alloy is selected only for convenience of preparation and investigation; however, once all alloy constraints are settled-upon and optimized, workers will likely prefer to deposit by "co-evaporation", sputtering or other known reliable methods of high volume production, i.e., by a method yielding a more truly homogeneous alloy to the extent feasible. Such a laminar film may be somewhat suspect as to homogeneity, etc., and thus is "non-optimal" for most applications. However, it is considerably quicker, cheaper and more convenient to set-up on a first approximation basis; e.g., vs. a co-evaporation arrangement].

Results
Generally like Ex. II, except that, rather than "islands" as described (and shown in Figure 11, etc.), a more "filament-like", semi-discontinuous form is deposited—this is shown in the 100,000×TEM, Figure 10 and, idealized, in Figure 8; with a pair of spaced ± electrodes also shown. This "quasi-island" ("insular" or "peninsular") form seems to "agglomerate" in the described manner, forming "globs" which are more discontinuous ("quasi-pits") in the above-described manner of Ex. I, etc., and thus is assumed functionally similar. However, these filamentary peninsulae exhibit a much lower electrical resistance laterally (still quite high though) than the "islands" of Ex. I, etc.—yet since they function similarly to write an

11

"agglomerate-hole" it is assumed they retain much of the "thermal isolation" of the aforementioned "islands". In common with the "islands", such a filamentary configuration may also be characterized as "insular". It records like the other "insular" films forming "agglomerate holes".

Sensitivity here was maximal; better than with pure gold (Ex. I)—e.g., approximately as "sensitive" as a tellurium absorber; often better, (e.g., about ½ the sensitivity of "Te Example" has been measured). That is, information can be satisfactorily "written" on the gold-lead tri-layer here in the power regime of 5—15 mW/10—100 n.sec. (or 100—1000 p.J.). More specifically, about 5 mW for as little as 40 n.sec. is seen to "switch reflectivity". Some samples even "switch" in about 10—15 n.sec. at 1—2 mW; others in less time at 10 mW—all yielding satisfactory read-out (e.g., 30—40 dB S/N, etc.). This is really astonishing—it is many times the sensitivity level that theory predicted and is really contrary to what the literature teaches one to expect. However, archivability was very poor (unacceptable for most purposes, as with pure Au and Au-Sb). And, as with Au/Sb relatively little "ejecta" is observed.

## Claims

1. A method for detecting fire, said method including; provision on a transparent substrate (f) of an absorber layer (ab) initially opaque and operative to become transparent in consequence of incidence of energy thereon from a thermal source; direction of an incident light beam $(b_i)$ onto said absorber layer (ab); and detection $(D_2)$ of passage $(b_t)$ of said incident light beam $(b_i)$ through said absorber layer (ab) and said transparent substrate (f) indicatively of incidence having occurred of said energy on said absorber layer (ab); said method being characterised by; said thermal source being fire or flames; by said absorber layer (ab) being a gold alloy layer in the form of a finely divided plurality of islands (V); by said incident light beam $(b_i)$ being periodically incident on said absorber layer (ab) to heat said absorber layer (ab) to a level insufficient to render said absorber layer (ab) transparent in the absence of said energy; and by said absorber layer (ab) being rendered transparent by agglomeration of said islands (V) into larger globules (i, r, e) having a cross-sectional area less than that possessed, pre-agglomeration, by those islands (V) which have agglomerated.

2. A method according to Claim 1 wherein said absorber layer (ab) comprises gold alloyed with tin.

3. A method according to Claim 2 including the step of laying down said gold and said alloying tin in said absorber layer (ab) in alternately deposited island layers of pure gold and pure tin.

4. A method according to Claim 1 wherein said absorber layer (ab) comprises gold alloyed with lead.

5. A method according to Claim 4 including the step of laying down said gold and said lead in said absorber layer (ab) in alternately deposited island layers of pure gold and pure lead.

6. A method according to Claim 1 wherein said absorber layer (ab) comprises gold alloyed with antimony.

7. A method according to Claim 6 including the step of laying down said gold and said antimony in alternately deposited layers of pure gold and pure antimony.

8. A method according to any of the preceding claims including use of a tin strike layer between said absorber layer (ab) and said substrate (f).

9. A method according to any of the preceding claims wherein said absorber layer (ab) is operative to reflect $(b_r)$ said incident light beam $(b_i)$ prior to incidence of said energy, said method including the step of detecting $(D_1)$ if said incident light beam $(b_i)$ is reflected.

10. A method according to any of the preceding claims including providing said incident light beam $(b_i)$ from a laser (LS).

11. A method according to any of the preceding claims including provision of a polymer overcoat (OC) on said absorber layer (ab).

## Patentansprüche

1. Verfahren zur Wahrnehmung eines Feuers, welches Verfahren umfaßt: Vorsehen einer Absorberschicht (ab), welche anfänglich undurchsichtig ist und infolge von Energieeinfall von einer Wärmequelle auf sie durchsichtig wird, auf einem transparenten Substrat (f); Ausrichtung eines einfallenden Lichtstrahls $(b_i)$ auf die Absorberschicht (ab); und Wahrnehmung $D_2)$ des Durchtritts $(b_t)$ des einfallenden Lichtstrahls $(b_i)$ durch die Absorberschicht (ab) und das transparente Substrat (f), wobei dies anzeigt, daß der Einfall der genannten Energie auf der Absorberschicht (ab) stattgefunden hat; wobei dieses Verfahren dadurch gekennzeichnet ist, daß die Wärmequelle von Feuer oder Flammen gebildet wird; daß die Absorberschicht (ab) eine Goldlegierungsschicht in Form einer feinverteilten Vielzahl von Inseln (V) ist; daß der einfallende Lichtstrahl $(b_i)$ periodisch auf die Absorberschicht (ab) einfällt, um die Absorberschicht (ab) auf ein Wärmeniveau aufzuheizen, welches nicht ausreicht, um die Absorberschicht (ab) in Abwesenheit der genannten Energie durchsichtig werden zu lassen; und dadurch, daß die Absorberschicht (ab) durch Zusammenballung der Inseln (V) zu größeren Kugeln (i, r, e) durchsichtig wird, welche Kugeln eine Querschnittsfläche haben, die kleiner ist als diejenige, welche die Inseln (V), welche sich zusammengeballt haben, vor der Zusammenballung besaßen.

2. Verfahren nach Anspruch 1, bei dem die Absorberschicht (ab) mit Zinn legiertes Gold umfaßt.

**0 097 430**

3. Verfahren nach Anspruch 2, welchés den Schritt einschließt, daß das Gold und das legierende Zinn in der Absorberschicht (ab) in alternierend aufgebrachten Inselschichten von reinem Gold und reinem Zinn aufgetragen werden.

4. Verfahren nach Anspruch 1, bei dem die Absorberschicht mit Blei legiertes Gold umfaßt.

5. Verfahren nach Anspruch 4, welches den Schritt umfaßt, daß das Gold und das Blei in der Absorberschicht (ab) in alternierend aufgebrachten Inselschichten von reinem Gold und reinem Blei aufgetragen werden.

6. Verfahren nach Anspruch 1, bei dem die Absorberschicht (ab) mit Antimon legiertes Gold umfaßt.

7. Verfahren nach Anspruch 6, welches den Schritt umfaßt, daß das Gold und das Antimon in alternierend aufgebrachten Schichten von reinem Gold und reinem Antimon aufgetragen werden.

8. Verfahren nach einem der vorstehenden Ansprüche, welches die Verwendung einer dünnen Niederschlagschicht (strike layer) von Zinn zwischen der Absorberschicht (ab) und dem Substrat (f) umfaßt.

9. Verfahren nach einem der vorstehenden Ansprüche, wobei die Absorberschicht (ab) zur Reflexion $(b_r)$ des einfallenden Lichtstrahls $(b_i)$ ausgelegt ist, bevor die Energie einfällt, welches Verfahren den Schritt einschließt, festzustellen $(D_1)$, ob der einfallende Lichtstrahl $(b_i)$ reflektiert wird.

10. Verfahren nach einem der vorstehenden Ansprüche, bei dem der einfallende Lichtstrahl $(b_i)$ von einem Laser (LS) erhalten wird.

11. Verfahren nach einem der vorstehenden Ansprüche, bei dem eine Polymer-Überzugsschicht (OC) auf der Absorberschicht (ab) vorgesehen wird.

**Revendications**

1. Procédé de détection d'incendie, procédé consistant à réaliser un support transparent (f) formé d'une couche absorbante (ab) initialement opaque et qui devient transparente sous l'effet de l'énergie incidente provenant d'une source thermique; procédé selon lequel on dirige un faisceau de lumière $(b_i)$ sur la couche absorbante (ab) et on détecte $(D_2)$ le passage $(b_t)$ du faisceau de lumière incidente $(b_i)$ à travers la couche absorbante (ab) et le support transparent (f) indiquant qui'il y a eu incidence de l'énergie dans la couche absorbante (ab), procédé caractérisé en ce que la source thermique est un feu ou des flammes; la couche absorbante (ab) est une couche d'alliage d'or sous la forme d'un ensemble d'îlots (V) finement divisés; le faisceau de lumière d'incidente $(b_i)$ tombe périodiquement sur la couche absorbante (ab) pour chauffer la couche absorbante (ab) à un niveau ne permettant pas de rendre cette couche absorbante (ab) transparente en l'absence de ladite énergie et cette couche absorbante (ab) devient transparente par l'agglomération des iîlots (V) en des globules plus grands (i, r, e) ayant une surface de section inférieure à celle présentée avant pré-agglomération par les îlots (V) qui ont été ainsi agglomérés.

2. Procédé selon la revendication 1, caractérisé en ce que la couche absorbante (ab) est de l'or allié à de l'étain.

3. Procédé selon la revendication 2, caractérisé en ce qu'on dépose l'or et l'étain d'alliage dans la couche absorbante (ab) en des couches d'îlots déposées alternativement et formées d'or pur et d'étain pur.

4. Procédé selon la revendication 1, caractérisé en ce que la couche absorbante (ab) est de l'or allié à du plomb.

5. Procédé selon la revendication 4, caractérisé en ce qu'on dépose l'or et le plomb dans la couche absorbante (ab) suivant des couches d'or pur et de plomb pur en îlots déposés en alternance.

6. Procédé selon la revendication 1, caractérisé en ce que la couche absorbante (ab) est de l'or pur allié à de l'antimoine.

7. Procédé selon la revendication 6, caractérisé en ce qu'on dépose l'or et l'antimoine en des couches alternées d'or pur et d'antimoine pur.

8. Procédé selon l'une quelconque des revendications précédentes, caractérisé en ce qu'on utilise une couche d'étain de rencontre entre la couche absorbante (ab) et le support (f).

9. Procédé selon l'une quelconque des revendications précédentes, caractérisé en ce que la couche absorbante (ab) réfléchit $(b_r)$ le faisceau de lumière incidente $(b_i)$ avant l'incidence de l'énergie, ce procédé consistant à détecter $(D_1)$ si le faisceau de lumière incidente $(b_i)$ est réfléchi.

10. Procédé selon l'une quelconque des revendications précédentes, caractérisé en ce que le faisceau de lumière incidente $(b_i)$ est fourni par un laser (LS).

11. Procédé selon l'une quelconque des revendications précédentes, caractérisé en ce que la couche absorbante (ab) est revêtu d'un polymère (OC).

13

0 097 430

## FIG.1.

## FIG.2.

## FIG.3.

1

# FIG.4.

# FIG.5.

# FIG.6.

# FIG.7.

## REFLECTANCE OF TRILAYERS.

FIG.9.

FIG.10.

0 097 430

FIG.11.                    FIG.12.                    FIG.13.